# Europäisches Patentamt

## European Patent Office

## Office européen des brevets

(11) Veröffentlichungsnummer: **0 074 022**
**B1**

(12) # EUROPÄISCHE PATENTSCHRIFT

(45) Veröffentlichungstag der Patentschrift:
25.11.87

(21) Anmeldenummer: **82107828.4**

(22) Anmeldetag: **25.08.82**

(51) Int. Cl.⁴: **G 01 N 24/08**

(54) **Kernspin-Tomograph.**

(30) Priorität: **07.09.81 DE 3135335**

(43) Veröffentlichungstag der Anmeldung:
**16.03.83 Patentblatt 83/11**

(45) Bekanntmachung des Hinweises auf die Patenterteilung:
**25.11.87 Patentblatt 87/48**

(84) Benannte Vertragsstaaten:
**FR GB NL**

(56) Entgegenhaltungen:
**DE-A-2 936 465**
**DE-A-2 951 537**
**GB-A-2 048 490**
**US-A-4 070 611**

**JOURNAL OF PHYSICS E-SCIENTIFIC INSTRUMENTS, Band 13, Nr. 7, Juli 1980, Seiten 947-955, The Institute of Physics, London, G.B. J. M. S. HUTCHINSON et al.: "A whole-body NMR imaging machine"**
**Journal of Magnetic Resonance, Vol. 18, (1975), S. 69-83**

(73) Patentinhaber: **Siemens Aktiengesellschaft Berlin und München, Wittelsbacherplatz 2, D-8000 München 2 (DE)**

(72) Erfinder: **Löffler, Wilfried, Dr., Hintere Gasse 15, D-8522 Herzogenaurach (DE)**
Erfinder: **Oppelt, Arnulf, Dr., Am Eichengarten 7, D-8520 Buckenhof (DE)**
Erfinder: **Siebold, Horst, Dr., Starenweg 3, D-8520 Erlangen (DE)**

**Beschreibung**

Die Erfindung betrifft ein Gerät der im Oberbegriff des Anspruchs 1 genannten Art.

Verfahren, die es gestatten, das Innere von Körpern von außen unter Anwendung von Kernspin-Resonanzeffekten bildlich darzustellen, sind auch unter Bezeichnungen wie Zeugmatographie, Spin-Imaging, Spin-Mapping oder FONAR, bekannt geworden. Mit Hilfe solcher Verfahren ist es möglich, die Dichte bestimmter Isotope sowie die Verteilung der kernmagnetischen Relaxationszeiten über einen Körperquerschnitt abzubilden. Für die medizinische Diagnostik ist dabei von besonderer Wichtigkeit der an Wasser gebundene Wasserstoff. Damit kann man auf nichtinvasivem Wege Informationen über den physikalischen und chemischen Zustand lebenden Gewebes erhalten. Als Meßgrundlage werden dazu die bekannten Phänomene der magnetischen Kernspin-Resonanz herangezogen.

Bei der Durchführung von Diagnostikverfahren vorliegender Art wird der zu untersuchende Körper einem magnetischen Gleichfeld $B_0$ ausgesetzt und die nachzuweisenden Kernisotope werden durch ein Hochfrequenzfeld $B_1$ zur Präzession angeregt. $B_1$ muß dabei die durch das gyromagnetische Verhältnis gegebene Frequenz $\omega_0 = \gamma \cdot B_0$ haben. Die Zuordnung des infolge der Präzessionsbewegung in einer Empfängerspule nachweisbaren Kernresonanzsignals zum Ort seiner Entstehung erfolgt durch die Anwendung linearer magnetischer Feldgradienten, wie z. B. von P.C. Lauterbur in "Nature" 242 (1973) Seiten 190/191 beschrieben.

Wenn $G_x$ die Stärke des Feldgradienten in x-Richtung ist, so ergibt sich die lokale Kernresonanzfrequenz $\omega(x)$ zu:

$$\omega(x) = \gamma \, (B_0 + G_x \cdot x).$$

Damit ist es möglich, das Kernresonanzsignal anhand seiner Frequenz einem bestimmten Ort entlang der x-Richtung zuzuordnen. Durch sukzessive Anwendung linearer Feldgradienten $G_x$, $G_y$ und $G_z$ in allen drei Raumrichtungen x, y, z ist auch eine dreidimensionale Lokalisierung in einem ausgedehnten Objekt möglich.

Bei einem aus der US-A-40 70 611 bekannten Gerät wird innerhalb eines Abtastbezirks die Größe eines Grundmagnetfeldes und einer Hochfrequenz so gewählt, daß die kernmagnetische Resonanz angeregt wird. Ein 90°-Hochfrequenzimpuls wird senkrecht zur Richtung des Grundmagnetfeldes angelegt, wobei seine Intensität so gewählt wird, daß die magnetischen Momente der Kerne um 90° bezüglich des Grundmagnetfeldes ausgelenkt werden. Nach Beendigung des 90°-Impulses, zum Zeitpunkt $t_0$, tritt das FID-Signal auf. Sofort nach Beendigung des 90°-Impulses bis zu einer vorgegebenen Zeit $t_x$ wird ein x-Gradient des Magnetfeldes eingeschaltet. Nach Ablauf der Zeit $t_x$ wird für eine Zeit $t_y$ ein y-Gradient eingeschaltet. Nach Ablauf der Zeit $t_y$ wird der y-Gradient ausgeschaltet und ein z-Gradient eingeschaltet. Gleichzeitig mit der Einschaltung eines z-Gradienten wird das FID-Signal zu gleichen Zeitintervallen, z. B. 0,5 msec. mit einer bestimmten Zahl von Abtastungen N gemessen. Die Zeitspannen $t_x$ und $t_y$ werden relativ zueinander von einem FID-Signal zum nächsten geändert, so daß nach einem Satz von N FID-Signalen die Zeitspannen $t_x$ und $t_y$ relativ zueinander in einem weiten Bereich variieren. Die gemessenen Werte werden in einem Computer abgespeichert und der Ablauf wird mit einem Wechsel der z- und y-Gradienten wiederholt. Während der $t_y$-Periode werden die FID-Signale zu gleichen Zeitintervallen, z. B. 0,5 msec. N-mal für N FID-Signale mit einem sich ändernden Verhältnis von $t_y$ zu $t_z$ abgetastet. Entsprechend erhält man einen dritten Satz von Kernspin-Echos, indem man die z-Gradienten für die Periode $t_z$ und die x-Gradienten für die Periode $t_x$ vertauscht und eine Zahl N von FID-Signalen mit sich ändernden Verhältnissen von $t_z$ zu $t_y$ zu N Abtastzeitpunkten während der Periode $t_x$ abtastet.

Eine einfache Implementierung dieses Verfahrens bereitet Schwierigkeiten, da zum einen eine sehr kurze Anstiegszeit der Gradientenstromimpulse verlangt wird und zum anderen jede praktisch unvermeidbare Grundfeldinhomogenität zu einer Verringerung des Signals führt. Das in der vorliegende Erfindung beschriebene Verfahren wird durch beide Unzulänglichkeiten nicht oder nur unwesentlich beeinflußt.

Aus der DE-A-29 36 465 ist ein Kernspin-Tomograph bekannt, bei dem die Probe zuerst mit einem Feldgradienten $G_x$ einem selektiven 90°-Hochfrequenzimpuls ausgesetzt wird. Unmittelbar nach dem Ende des ersten Hochfrequenzimpulses wird der Gradient in die z-Richtung umgeschaltet und die Magnetisierung kann während der Zeit $t_1$ in diesem Gradienten frei zerfallen. Der danach angelegte selektive Impuls dreht die Spins innerhalb einer Schicht mit einer gewissen Dicke um 180°. Dies bewirkt ein Echosignal zur Zeit $t_2$ nach dem Ende des HF-Impulses. Zum Zeitpunkt $t_2$ des Echo-Maximums wird der Gradient in die y-Richtung umgeschaltet und das resultierende Kernresonanz-Signal ausgelesen. Unmittelbar nach der beschriebenen Pulsfolge wird sofort eine zweite gleichartige Pulsfolge angewendet, um die Spins entlang einer Linie an anderer Stelle zu untersuchen.

Aus dem "Journal of Magnetic Resonance", 18, 69-83 (1975), Seite 69 ist ein Kernspin-Tomographie-Verfahren bekannt, bei dem in einem ersten Zeitintervall ein x-Gradient, in einem anschließenden zweiten Zeitintervall ein y-Gradient, und in einem dritten wiederum unmittelbar anschließenden Zeitintervall ein dritter Gradient zugeschaltet wird. Während des dritten Zeitintervalls wird der freie Induktionsabfall gemessen. Dieses Experiment wird für einen vollen Satz gleichbeabstandeter Werte des ersten und des zweiten Zeitintervalls durchgeführt.

Schließlich ist aus der GB-A-20 48 490 ein Kernspin-Tomographie-Verfahren bekannt, bei dem einem statischen Magnetfeld ein z-Gradient zusammen mit einem selektiven 90°-Hochfrequenzimpuls aufgeprägt wird, um Spinresonanz in einem vorgegebenen Streifen zu erzeugen. Der z-Gradient wird dann während eines begrenzten Zeitintervalls, währenddessen das freie Induktionssignal nur teilweise abklingt, durch einen x-Gradienten ersetzt. Der x-Gradient ändert sich in einer Richtung, die senkrecht zu einer ausgewählten Scheibe des Streifens steht. Der x-Gradient wird dann sofort durch einen y-(Lese-)Gradienten ersetzt, der sich in einer Richtung senkrecht sowohl zum x- als auch zum z-Gradienten hin ändert. Dann wird der freie Induktionsabfall gemessen. Diese Abfolge wird zyklisch wiederholt, wobei zwischen zwei Zyklen jeweils eine Pause auftritt.

Aufgabe der Erfindung ist es, bei gegebener technisch unvermeidbarer Inhomogenität des magnetischen Gleichfeldes ein bezüglich Signal-Rausch-Verhältnis und Freiheit von Artefakten optimales Schnittbild eines Körpers zu erzeugen.

Diese Aufgabe wird erfindungsgemäß gelöst durch die Merkmale des Patentanspruchs 1.

Bei den folgenden weiteren Erläuterungen von Details und Vorteilen der Erfindung wird auf bekannte Begriffe aus der Kernresonanz-Impulsspektroskopie, z. B. 90°- und 180°-Impuls, zurückgegriffen und auf die in den Figuren dargestellten Ausführungsbeispiele.

In der Fig. 1 ist schematisch das Blockschaltbild des erfindungsgemäßen Kernspin-Tomographen dargestellt,

in der Fig. 2 in einem Diagramm eine Auftragung, die Abfolge der Hf- und z-Gradientenpulse, einer günstigen Pulsfolge,

in der Fig. 3 die entsprechende Abfolge der x-Gradientenpulse,

in der Fig. 4 die entsprechende Abfolge der y-Gradientenpulse für positive Gradientenwirkung $k_y$,

in der Fig. 5 die entsprechende Abfolge der y-Gradientenpulse für negative Gradientenwirkungen $k_y$,

in den Fig. 6 und 7 in einem Diagramm alternative Schaltfrequenzen für den y-Gradienten, wobei dieser so lange wie möglich eingeschaltet wird,

in der Fig. 8 eine Variante des Schaltschemas für die y-Gradientenspule,

in den Fig. 9 und 10 in einem Diagramm eine alternative Pulsfolge, für welche die Stromversorgung des y-Gradienten bipolar ausgelegt sein muß, und

in der Fig. 11 ein Beispiel des Anregungsschemas zur gleichzeitigen Messung mehrerer Schichten.

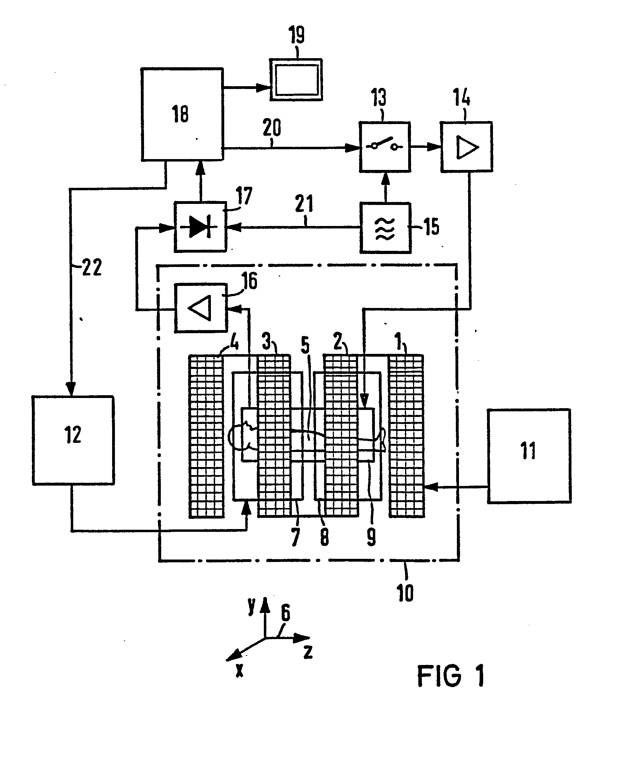

In der Fig. 1 sind mit 1 und 2 sowie 3 und 4 Spulen gekennzeichnet, mit welchen ein magnetisches Gleichfeld $B_0$ erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur sind der Übersichtlichkeit halber nur Spulen 7 und 8 gezeichnet, die zusammen mit einem Paar gegenüberliegender gleichartiger Spulen zur Erzeugung eines x-Gradienten dienen. Die gleichartigen nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Anregung der Kernresonanz und Aufnahme der Kernresonanzsignale dienende Hochfrequenzspule 9.

Die von einer strichpunktierten Linie 10 umgrenzten Spulen 1 bis 9 stellen das eigentliche Untersuchungsinstrument dar. Es wird von einer elektrischen Anordnung aus betrieben, die ein Netzgerät 11 zum Betrieb der Magnetspulen 1 bis 4 sowie eine Gradientenstromversorgung 12, an welcher die Spulen 7 und 8 sowie die weiteren Gradientenspulen liegen, umfaßt. Die sowohl zur Anregung als auch zur Aufnahme des Signals dienende Spule 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Zur Steuerung der Anordnung sind außerdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen.

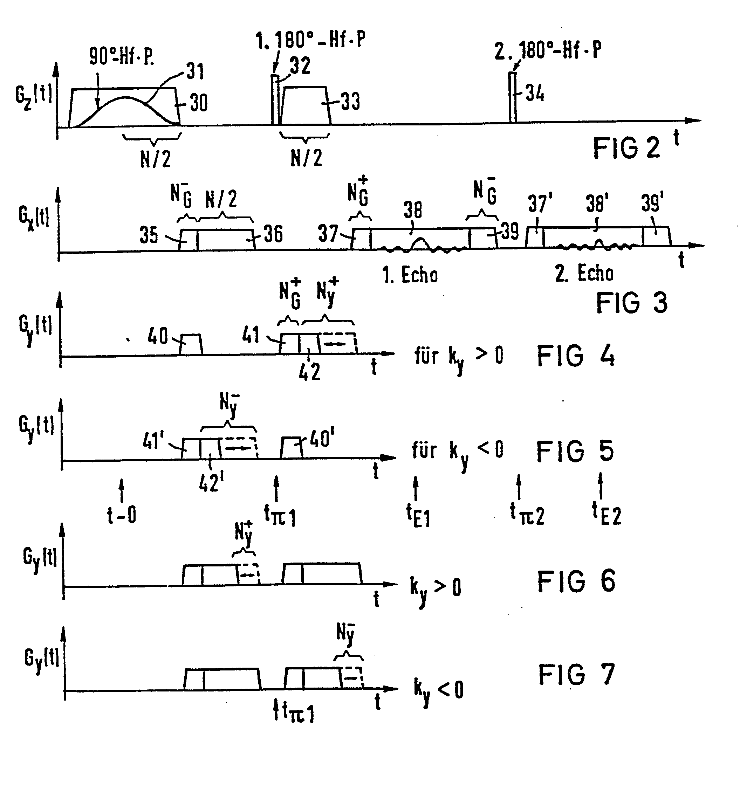

Darauf läuft nach Einschaltung des Grundfeldes mit Hilfe der Gradientenstromversorgung und des Hf-Sende- und Empfangssystems beispielsweise die in Fig. 2-4 skizzierte Sequenz ab. Es erfolgt zunächst die Anregung einer Schicht bei z=const durch einen selektiven 90°-Hf-Puls. Dazu wird der z-Gradient entsprechen der Zeitfunktion 30 eingeschaltet. Gleichzeitig wird ein Hf-Puls mit seiner durch 31 bezeichneten Einhüllenden eingestrahlt. Die Frequenz des Hf-Pulses richtet sich gemäß $\omega(z) = \gamma (B_0 + G_z \cdot z)$ nach der Lage z der anzuregenden Schicht. Die Länge des Pulses beträgt N mal ein Grundzeitraster $\Delta t$, das je nach der Stärke der Gradienten und der Dicke der gewünschten Schicht eingestellt wird und in der Größenanordnung von 100 µs liegt. N ist beispielsweise 128. Es folgen Gradientenstrompulse $G_x$ mit einer Länge von $(N_G^- + N/2) \cdot \Delta t$, bezeichnet mit 35 und 36, wobei die Zahl $N_G^-$ so gewählt werden muß, daß nach der Zeit $N_G^- \cdot \Delta t$ der Gradientenstrom seinen konstanten Wert nach der ansteigenden Flanke erreicht hat. Gleichzeitig wird der y-Gradient für eine Zeit $N_G^- \cdot \Delta t$, hier mit 40 bezeichnet (Fig. 4), eingeschaltet. Nach einem 180°-Hf-Puls 32 wird wieder der z-Gradient für $N/2 \cdot \Delta t$, hier mit 33 bezeichnet, eingeschaltet. Gleichzeitig wird der y-Gradient für eine Zeit von $(N_G^+ + N_y^+) \cdot \Delta t$ eingeschaltet (41, 42), womit für $N_y^+ = N/2 -1$ die Differenz der Wirkungen des y-Gradienten vor und nach dem 180°-Puls wie gewünscht im ersten Scan gleich $G_y \cdot \Delta t \cdot (N/2 -1)$ ist. Dabei ist vorausgesetzt, daß die Gradientenwirkung während der Zeit $N_G^- \cdot \Delta t$ (40) vor dem 180°-Puls (32) gleich der Gradientenwirkung während der Zeit $N_G^+ \cdot \Delta t$ (41) nach dem 180°-Puls ist. Im darauffolgenden x-Gradientenpuls der Dauer $(N_G^+ + N_G^-) \cdot \Delta t$ mit den Bezeichnungen 37, 38, 39 entsteht ein Echo des Kernresonanzsignals, das über die Hochfrequenzelektronik abgetastet und ausgegeben wird. Es ist zusätzlich möglich, mit Hilfe eines weiteren 180°-Pulses 34 und eines x-Gradientenpulses 37', 38', 39' ein weiteres Echo zu erzeugen und auszuwerten, das dem Fourierspektrum der untersuchten Schicht für einen invertierten Wellenzahlvektor in y-Richtung ($-k_y$) entspricht. In weiteren Scans werden die Experimente dann sinngemäß wiederholt, wobei die Dauer des y-Gradientenpulses 42 schrittweise bis auf Null reduziert wird und in den dann folgenden Scans der y-Gradientenpuls 40' nach dem 180°-Puls 32 konstant die Länge $N + _G \cdot \Delta t$ behält, während der y-Gradientenpuls 42' vor dem 180°-Puls von Null schrittweise auf $N/2 \cdot \Delta t$ verlängert wird. Liegt ein kompletter Datensatz für alle gewünschten Längen der y-Gradientenpulse vor, so wird dieser im Prozeßrechner einer zweidimensionalen Fourier-Transformation unterworfen, worauf das somit entstandene Bild an das Bildschirmsichtgerät 19 übergeben wird.

Die Beschränkung auf nur eine Schicht hält die Gesamtmeßzeit für ein Bild kurz, was für die medizinische Anwendung wichtig ist. Außerdem sind die Ansprüche an die Dynamik des Vorverstärkers 16 und der Analog-Digital-Wandler, die in Fig. 1 als Teil des Prozeßrechners betrachtet werden, kleiner als bei Verfahren, die gleichzeitig das Signal aus dem ganzen Volumenbereich verwerten.

Wie von A. Kumar, D. Welti und R. R. Ernst (J. Magn. Res. 18 (1975) 69) vorgeschlagen, kann man die Verteilung eines Kernresonanzparameters als Funktion des Ortes (x, y) mittels zweidimensionaler Fourier-Transformation aus gemessenen Signalwerten $S(t, N_y)$ berechnen, wenn diese die Fourier-Koeffizienten $S(k_x, k_y)$ dieser Verteilung darstellen. $k_x$ und $k_y$ beschreiben die Wellenzahlen der jeweiligen Richtung und sind gegeben durch

FIG1/25

FIG2/25

Beschreibt man die Phasenlage der durch den 90°-Hf-Puls erzeugten transversalen Magnetisierung eines Volumenelementes am Ort (x, y) durch eine komplexe Zahl in dem mit $\gamma \cdot B_0$ rotierenden Bezugssystem, so ist zu messen:

$$S(k_x, k_y) \sim \exp(i\, k_x \cdot x) \exp(i\, k_y \cdot y)$$

Die Messung des komplexen Signals $S(k_x, k_y)$ erfolgt apparativ durch phasenempfindliche Gleichrichtung mit dem Senderoszillator als Referenz. Um ein reelles N x N-Bild mit guter Schärfe und gutem Kontrast zu erhalten, genügt ein Wertevorrat

$$k_x = (-N/2) \cdot \Delta k_x --- (N/2 -1) \cdot \Delta k_x$$

$$k_y = (-N/2) \cdot \Delta k_y \Lambda - \varnothing.$$

Man müßte den Realteil des komplex zweidimensional fouriertransformierten Signals, die "Absorption", als Bildwert nehmen, und den Imaginärteil, die "Dispersion", verwerfen, da diese wegen ihrer weiten Flügel für die Abbildung nicht taugt.

In der Praxis tritt aber zu obigem Idealsignal noch ein unbekannter Phasenfaktor hinzu, der von Grundfeld-Inhomogenitäten und -Drifts und von nicht perfektem Elektronik-Abgleich herrührt. Dies bewirkt bei der rechnerischen Verarbeitung eine dispersive Beimischung zum realen Bildwert und damit eine Qualitätsverschlechterung.

Es ist daher besser, auch für $k_y$ einen vollständigen Wertevorrat, also doppelt so viele Pulsfolgen

$$k_y = (-N/2) \cdot \Delta_y --- (N/2 -1) \cdot \Delta k_y$$

zu messen, was zur Erlangung eines brauchbaren Signal-Rausch-Verhältnisses oft in der Praxis ohnehin notwendig ist. Damit ergibt die zwei-dimensionale Fouriertransformation einen komplexen Bildwert mit Imaginärteil = 0 im Idealfall, bzw. einen örtlich scharf und kontrastreich aufgelösten Absolutbetrag des komplexen Bildwertes, falls die oben genannten Störungen eine Phasendrehung oder einen Phasengang über die Bildebene verursachen.

Die gemäß Fig. 2-4 benutzte Pulsfolge erlaubt es, den vollständigen Wertebereich der Wellenzahlen $k_x$, $k_y$ (also auch die negativen) mit nur einer Polarität der Gradientenfelder zu erzeugen. Die Elektronik für das schnelle Schalten der Gradientenfelder ist sehr aufwendig und müßte an sich für jede Polarität separat installiert sein, falls die Polarität innerhalb einer Pulsfolge zur Ausmessung positiver und negativer $k_x$- und $k_y$-Komponenten gewechselt werden müßte.

Wir betrachten nun die Erzeugung der gewünschten $k_x$ und $k_y$-Werte mittels der vorgeschlagenen Pulsfolge in Fig. 3. Der x-Gradientenpuls 35, 36 vor dem 180°-Hf-Puls mit der Dauer $(N^-_G + N/2) \cdot \Delta t$, wobei $\Delta t$ ein festes Zeitraster ist, produziert eine Magnetisierung $M^-_{xy} \sim \exp(i\,k^-_x \cdot x)$, mit $k^-_x = (N^-_G + N/2) \cdot \Delta t \cdot \gamma G_x \cdot G_x$ ist die Stärke des x-Gradientenfeldes. Der erste y-Gradientenpuls 40 bzw. 42' erzeugt zusätzlich einen Phasengang in y-Richtung:

$$M^-_{xy} \sim \exp(i\,k^-_x \cdot x + i\,k^-_y \cdot y), \text{ mit}$$

$$k^-_y = N^-_G \Delta t \cdot \gamma\, G_y \text{ für } k_y > 0$$

$$k^-_y = (N^-_G + N^-_y)\, \Delta t\, \gamma\, G_y \text{ für } k_y \leqslant 0$$

in der ersten Variante (Fig. 4, 5). Der darauffolgende 180°-Hf-Puls 32 kehrt, gleich welche Phase er hat, die Vorzeichen der Phasen in der $M_{xy}$-Magnetisierung um:

$$M^+_{xy} \sim \exp(-i\,k^-_x \cdot x - i\,k^-_y \cdot y)$$

Der y-Gradient wird zum zweiten Mal eingeschaltet und liefert am Ende des Pulses 42 bzw. 40' die gewünschte Wellenzahl $k_y$ für $N^-_G = N^+_G$:

$$k_y\,(N^+_y) = \gamma\, G_y \cdot [-N^-_G + (N^+_G + N^+_y)]\, \Delta t = \gamma\, G_y\, N^+_y \cdot \Delta t > 0$$

$$k_y\,(N^-_y) = \gamma\, G_y\, [-(N^-_G + N^-_y) + N^+_G]\, \Delta t = -\gamma\, G_y\, N^-_y\, \Delta t \leqslant 0$$

Die zusätzlich eingebrachten Intervalle $N^+_G$ und $N^-_G$ 41 und 41' vermeiden, daß extrem kurze Pulse der Länge $1 \cdot \Delta t$, $2 \cdot \Delta t$ usw. geschaltet werden müssen; es ist dann nämlich technisch schwierig, die gewünschte Pulswirkung $\int G_y\,(t)dt = G_y \cdot N \cdot \Delta t$ exakt zu erhalten, de bei kurzen Zeitintervallen der Gradientenstrom schon wieder ausgeschaltet wird, bevor Strom und Feld ihren stationären Wert erreicht haben. Die Zusatzintervalle im y-Gradientenpuls stellen also die Linearität des Verlaufes der Wellenzahl $k_y$ als Funktion der variablen Taktzahl $N_y$ sicher.

Der zweite x-Gradient beginnt mit einem Zeitintervall $N^+_G \cdot \Delta t$, bezeichnet mit 37, währenddessen sich das Gradientenfeld stabilisiert und der Vorverstärker an der Empfangsspule sich von dem 180°-Hf-Puls und der Schaltflanke des x-Gradienten erholt. Bei kurzen Abfallflanken der Gradientenpulse ist $N^+_G = N^-_G$; ansonsten kann man $N^+_G$ um einige wenige Takte $\Delta t$ länger wählen als $N^-_G$, um den Beitrag der Abfallflanke des x-Gradientenvorlaufes zu kompensieren; stattdessen kann auch das Abtasten der Meßwerte um einen entsprechenden Zeitverzug verschoben werden.

Wenn der erste Meßwert zu Beginn des Intervalles 38 aufgenommen wird, hat die Magnetisierung die Gestalt:

$$M_{xy} \sim \exp[i\,\gamma\, G_y\, N_y \cdot \Delta t \cdot y].$$

$$\exp[i\gamma\, G_x\,(-N^-_G - N/2 + N^+_G)\, \Delta t \cdot x]$$

und damit auch das Signal die zuvor geforderte Form

$$S(k_x, k_y) \sim \exp[i\,k_x\, x] \cdot \exp[i\,k_y\, y]$$

mit dem gewünschten Wertebereich für $k_x$, $k_y$. Für $k_x = 0$, also zum Zeitpunkt $t = t_{E1}$, sind alle Volumenelemente bezüglich x ohne Phasengang, so daß ein Signalmaximum, ein "Kernspin-Echo" entsteht.

Der z-Gradient 33 nach dem 180°-Hf-Puls 32 dient dazu, den Phasengang über der Schichtdicker $\Delta z$ zu minimalisieren, um so ein möglichst starkes Echo zu erzeugen. Bei symmetrischen 90°-Hf-Pulsen wird dies von einem negativen z-Gradienten oder, wie in unserem Falle, von einem positiven z-Gradienten nach einem 180°-Hf-Puls geleistet, der ungefähr halb so lang wie der 90°-Hf-Puls 31 ist (gleiche z-Gradientenfeldstärke vorausgesetzt).

Die Verwendung eines zentralen 180°-Hf-Pulses zur Erzeugung des Signals hat neben den monopolaren Gradienten noch einen weiteren, sehr wichtigen Vorteil. Zum Zeitpunkt $t_{E1}$ des Echos ist der Phasenfehler durch eine Grundfeld-Inhomogenität $\Delta B_0$, der sich vor dem 180°-Hf-Puls zu $\gamma \cdot \Delta B_0 \cdot t_{E1}/2$ aufsummiert hat, wieder zu Null geworden; ebenso ist der Phasengang innerhalb eines Volumenelementes aufgrund von $\delta \Delta B_0/\delta x$, $\delta \Delta B_0/\delta y$, $\delta \Delta B_0/\delta z$ zu diesem Zeitpunkt Null. Das Signal wird also mit geringstmöglichen Phasenfehlern und deshalb auch mit einer durch die Grundfeldinhomogenität kaum beeinträchtigten Intensität gemessen. Das Signal wird nur durch den unvermeidlichen Phasengang gedämpft, der von den gewollten Gradientenfeldern $G_x$ und $G_y$ herrührt.

Durch die gleichzeitige Einwirkung der Gradientenfelder $G_x$ und $G_y$ ist es bei der Erfindung gelungen, die Pulsfolge bis zum Echo sehr kurz zu halten. Das Signal wird insgesamt im wesentlichen durch die echte transversale Relaxationszeit $T_2$ der betrachteten Kerne in ihrer stofflichen Umgebung bestimmt:

$$S\ (k_x,\ k_y) \sim exp\ (-t_{E1}/T_2) \cdot exp\ (i\ k_x \cdot x + i\ k_y \cdot y)$$

Da bei jeder Pulsfolge die Meßwerte zum gleichen Zeitpunkt nach der Anregung erfaßt werden, sind auch alle $k_y$-Fourierkomponenten im Signal gleich gewichtet.

Durch einen weiteren 180°-Hf-Puls 34 nach dem oben beschriebenen Meßvorgang kann ein zweites Echo erzeugt werden. Direkt nach diesem zweiten 180°-Impuls hat die Magnetisierung die Gestalt:

$$M_{xy}\ (t > t_{\pi2}) \sim exp\ [-i\ k_y \cdot y - i\ \gamma\ G_x\ (N/2 + N^-_G)\ \Delta t \cdot x]$$

Symmetrisch zum zweiten 180°-Hf-Puls wird der x-Gradient entsprechend dem ersten Auslese-Intervall wieder eingeschaltet (37', 38', 39'). Während die Wellenzahlen $k_x$ wieder von $\gamma\ G_x \cdot (-N/2) \cdot \Delta t$ bis $\gamma\ G_x \cdot (N/2 -1) \cdot \Delta t$ wie beim ersten Echo laufen, ist der Wellenvektor $k_y$ nun invertiert, was man bei der rechnerischen Verarbeitung berücksichtigen muß. Im zweiten Echo entsteht also:

$$S_2\ (k_x,\ k_y) \sim exp\ (-t_{E2}/T_2) \cdot exp\ (i\ k_x\ x - i\ k_y\ y)$$

$$= exp\ -(t_{E2} - t_{E1})/T_2 \cdot S\ (k_x,\ -k_y)$$

In gleicher Weise lassen sich dann auch weitere Echos erzeugen, wobei die ungeraden und die geraden jeweils gleiche Information beinhalten.

Bei den Hf-Pulsen empfiehlt es sich bekanntermaßen, von Puls zu Puls das Vorzeichen zu wechseln, damit Auswirkungen kleiner Hf-Feldstärke-Abweichungen vom Nominalwert sich nicht aufaddieren können.

Da es bei der Erzeugung der Wellenzahl $k_y$ nur auf die Differenz zwischen den y-Gradienten-Pulslängen vor und nach dem ersten 180°-Hf-Puls ankommt, sind dafür weitere Varianten denkbar. Eine zweite ist in Fig. 6, 7 dargestellt. Während bei der ersten Variante die y-Gradienten mindestens $N_G$, aber sonst so kurz wie möglich angeschaltet sind, werden sie bei der zweiten so lange wie möglich angeschaltet; dies ist vorteilhaft, wenn die Einschwingzeit des y-Gradientenfeldes sehr lang ist. Für positive $k_y$-Werte variiert das Einschaltintervall vor dem 180°-Impuls von $N^-_G \cdot \Delta t$ bis $(N^-_G + N/2 -1) \cdot \Delta t$ bei einer konstanten Einschaltzeit von $(N^+_G + N/2) \cdot \Delta t$ nach dem 180°-Impuls. Umgekehrt wird für negative $k_y$-Werte die Einschaltdauer nach dem 180°-Impuls von $(N^+_G + N/2 -1) \cdot \Delta t$ bis $N^+_G \cdot \Delta t$ geändert, während vorher die Einschaltzeit konstant $(N^-_G + N/2) \cdot \Delta t$ beträgt.

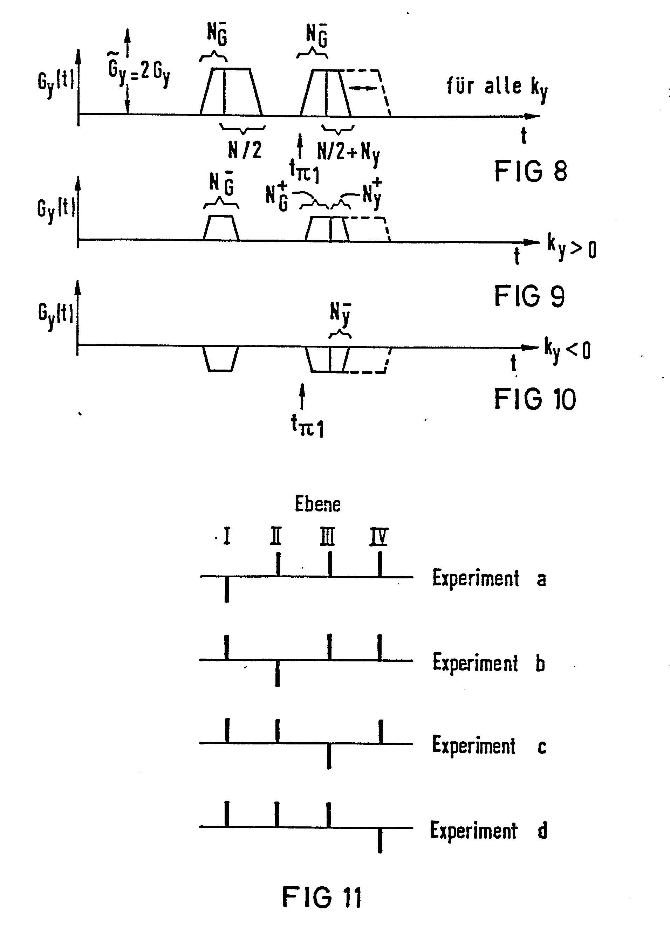

In Fig. 8 ist die dritte Variante eines möglichen Schaltschemas für die y-Gradientenspule dargestellt, die anstelle der Variante 1 aus Bild 2 verwendet werden kann. Sowohl positive als auch negative Wellenzahlen $k_y$ werden durch alleinige Variation des zweiten y-Gradienten erreicht, während der erste y-Gradient vor dem 180°-Hf-Puls konstante Länge aufweist. Um insgesamt N Längenabstufungen zu realisieren, werden entweder die Zeitschritte $\tilde{\Delta}t = \Delta t/2$ halb so lang wie bei Variante 1 gewählt; als Ausgleich muß dann die Amplitude $\tilde{G}_y$ des y-Gradientenfeldes verdoppelt werden: $\tilde{G}_y = 2 \cdot G_y$, und im allgemeinen $\tilde{G}_y = 2 \cdot G_x$. Es kann aber auch bei unverändertem Zeitraster und unveränderter Gradientenstärke gearbeitet werden. Nur muß dann der 180°-Hf-Puls um $N/2 \cdot \Delta t$ und das Ausleseintervall mit $N \cdot \Delta t$ gegenüber dem bisherigen Zeitablauf nach hinten verschoben werden, um noch alle Vorteile der Spin-Echo-Methode voll auszunutzen. Das alleinige Fortschalten des y-Gradienten nach dem 180°-Hf-Puls ist günstiger, wenn das Hf-Feld inhomogen ist.

Man kann die Verdoppelung der Feldamplitude des y-Gradienten auch umgehen, wenn man seine Stromversorgung bipolar auslegt, wie es in Variante 4 in Fig. 9, 10 gezeigt dargestellt ist. Durch die Zusatzintervalle $N^-_G$ und $N^+_G$ ist die präzise Präparation der kleinen $k_y$-Werte unproblematisch. Es ist natürlich dafür Sorge zu tragen, daß der Betrag des negativen Gradientenstromes gleich dem des positiven ist.

Durch die phasenempfindliche Ausmessung vollständiger, symmetrischer Echos ist das Spektrum des Signals eines Ablaufs unter idealen Bedingungen reell; bei Störungen durch elektronische Phasenfehler und Grundfeld-Inhomogenitäten kann wiederum der Betrag des komplexen Spektrums als reelle Projektion ohne Verschlechterung der Abbildungseigenschaften verwendet werden.

Die Zusatzintervalle $N_G$ stellen die Konstanz der Gradientenfeldstärke während der Meßwerterfassung sicher.

Die Signalintensität wird wegen des zentralen 180°-Hf-Pulses durch Grundfeld-Inhomogenitäten kaum gedämpft; es können mehrere Echos in einem Ablauf gemessen werden.

Die beschriebenen Abbildungsverfahren können dahingehend modifiziert werden, daß durch den selektiven 90°-Impuls mehrere parallele Schichten gleichzeitig angeregt werden. Das Vorzeichen oder, anders ausgedrückt, die Phasenlage der Anregung wird dann für die einzelnen angeregten Schichten innerhalb einer sonst gleichen Meßsequenz sukzessive variiert, um mit Hilfe geeigneter Dekodierungsalgorithmen die Signalbeiträge der einzelnen Schichten aus dem Gesamtsignal gewinnen zu können. Da bei N parallelen gleichzeitig angeregten Schichten mindestens N Meßzyklen mit unterschiedlichem Anregungsvorzeichen für eine Dekodierung erforderlich sind, erhält man keine Verkürzung der Gesamtmeßzeit im Vergleich zur sukzessiven Messung der einzelnen Schichten. Man erhält jedoch ein um den Faktor $\sqrt{N}$ höheres Signal-Rausch-Verhältnis.

Fig. 11 zeigt als Beispiel eine geeignete Anregungssequenz für das gleichzeitige Ausmessen von vier Schichten. Bezeichnen $S_a - S_d$ die bei diesen Experimenten erhaltenen Summensignale und $S_I$ bis $S_{IV}$ die bei Anregung jeder einzelnen Schicht erwarteten Signale, so gilt:

$$-S_a + S_b + S_c + S_d = 4\,S_I$$

$$S_a - S_b + S_c + S_d = 4\,S_{II}$$

$$S_a + S_b - S_c + S_d = 4\,S_{III}$$

$$S_a + S_b + S_c - S_d = 4\,S_{IV}$$

Durch Anwendung der erfindungsgemäßen Anregungssequenz erhält man also in vier Messungen die Signale der vier Ebenen mit einem Rauschabstand entsprechend einer Mittelung über vier Meßzyklen. Eine Verallgemeinerung auf N gleichzeitig angeregte Schichten ist entsprechend dem in der DE-A-29 36 465 für N parallele Linien in einer Ebene angegebenen Verfahren ohne weiteres möglich.

**Patentansprüche**

1. Gerät zur Darstellung der in einer Querschnittsebene eines Körpers vorliegenden Verteilung einer Kernspineigenschaft, wie z. B. der Kernspindichte, in Form eines zeilenförmig angeordneten Bildpunktrasters mit jeweils N Bildpunkten pro Rasterzeile,

(a) mit Spulen (1-4), die ein im wesentlichen homogenes statisches Gleichmagnetfeld erzeugen, in die der Körper gebracht wird,

(b) mit Gradientenspulen (7, 8), einer Hochfrequenzspule (9) und einem Prozeßrechner (18), mit dem die Gradientenspulen (7, 8) und die Hochfrequenzspule (9) angesteuert werden; dadurch gekennzeichnet, daß der Prozeßrechner zur N-fachen Ausführung folgender Sequenz von Schritten ausbegildet ist:

(i) dem von den Spulen (1-4) erzeugten Gleichmagnetfeld wird ein von den Gradientenspulen (7, 8) erzeugtes Gradientenfeld $G_Z$ überlagert, dessen Richtung mit der des Gleichmagnetfeldes übereinstimmt und dessen Stärke sich in dieser oder einer dazu senkrechten Richtung ändert, und gleichzeitig wird die Hochfrequenzspule (9) mit einem HF-Impuls beaufschlagt, dessen Dauer das N-fache einer vorgegebenen Grundzeiteinheit $\Delta t$ beträgt und dessen Frequenz und Form so gewählt sind, daß nur die Spins in einer zum Feldstärkegradienten des ersten Gradientenfeldes senkrechten Ebene des Körpers in Resonanz mit dem Feld des HF-Impulses geraten,

(ii) nach Abschaltung des HF-Impulses und des ersten Gradientenfeldes werden dem Gleichmagnetfeld gleichzeitig ein zweites Gradientenfeld $G_x$ der Dauer $(N/2) \cdot \Delta t$ sowie ein drittes Gradientenfeld $G_y$ variabler Dauer überlagert, deren Feldrichtungen jeweils der des Gleichmagnetfeldes entsprechen und deren Feldstärkegradienten sowohl zueinander als auch bezüglich des Feldstärkegradienten des ersten Gradientenfeldes senkrecht verlaufen,

(iii) zu einem vorgegebenen Zeitpunkt nach Abschalten des zweiten und dritten Gradientenfeldes wird die Hochfrequenzspule (9) mit einem 180° HF-Impuls beaufschlagt, nach dessen Ende dem Gleichmagnetfeld gleichzeitig wieder das erste Gradientenfeld für die Dauer $(N/2) \cdot \Delta t$ sowie das dritte Gradientenfeld für eine variable Zeitspanne überlagert wird,

(iv) dem Gleichmagnetfeld wird nach Abschaltung der Gradientenfelder gemäß Schritt (iii) erneut das zweite Gradientenfeld für die Dauer $N \cdot \Delta t$ überlagert und die Werte des von dem 180° HF-Impuls hervorgerufenen Spin-Echosignals werden in Anwesenheit des zweiten Gradientenfeldes zu N aufeinanderfolgenden Zeitpunkten erfaßt und einer Fouriertransformation unterworfen,

wobei jeweils von einer Sequenz zur nächsten die Dauer des dritten Gradientenfeldes $G_y$ jeweils in Schritt (ii) bzw. in Schritt (iii) so verändert wird, daß die Differenz der vor und nach dem 180° HF-Impuls über dieses Gradientenfeld gebildeten Zeitintegrale nach N Sequenzen die Werte vom (-N/2)-fachen bis zum (N/2-1)-fachen eines Inkrements $\Delta t \cdot G_y$ durchlaufen hat.

2. Gerät nach Anspruch 1, dadurch gekennzeichnet, daß in den auf den ersten Schritt folgenden Schritten endliche Anstiegs- und Einschwingzeiten der Gradientenfelder kompensiert werden, indem der Dauer der Anlegung der Gradientenfelder konstante Verlängerungen hinzugefügt werden, wobei der Beitrag des Zusatzintervalls der Länge $N^-_G \cdot \Delta t$ vor dem 180°-HF-Impuls durch den Beitrag des Zusatzintervalls $N^+_G \cdot \Delta t$ nach dem 180°-HF-Impuls einschließlich des Einflusses der endlichen Anstiegszeiten kompensiert wird, wobei das Zusatzintervall mittels der vorgegebenen Zahlenwerte $N^-_G$ und $N^+_G$ so groß gewählt wird, daß das Gradientenfeld stationär ist.

3. Gerät nach Anspruch 1,

dadurch gekennzeichnet, daß mittels eines zweiten 180°-HF-Impulses, der gegenüber demjenigen nach Schritt (iii) entgegengesetztes Vorzeichen besitzt und der zeitlich gesehen mittig zwischen dem zweiten Gradientenfeld nach Schritt (iv) und einem nachfolgend zusätzlich angelegten, dem Gradientenfeld nach Schritt (iv) entsprechenden zweiten Gradientenfeld liegt, das vom zweiten 180°-HF-Impuls hervorgerufene Spin-Echosignale in entsprechender Weise wie in Schritt (iv) erfaßt wird.

4. Gerät nach Anspruch 3,

dadurch gekennzeichnet, daß in weiteren Schritten weitere 180°-HF-Impulse mit jeweils alternierender Phasenlage angelegt und anschließend die Spin-Echosignale entsprechend Schritt (iv) erfaßt werden und daß vor den rekonstruierenden Fourier-Transformationen die Meßwerte aller ungeraden Echos aufsummiert werden und diejenigen aller geraden Echos ebenfalls.

5. Gerät nach Anspruch 4,

dadurch gekennzeichnet, daß vor der Aufsummierung Differenzen oder Quotienten zwischen früheren und späteren Echos gebildet werden.

6. Gerät nach einem der Ansprüche 3 oder 4,

dadurch gekennzeichnet, daß bei im Sinne hinreichender spektraler Breite genügend starken, kurzen 180°-HF-Impulsen das zweite Gradientenfeld ab dem Schritt (iv) eingeschaltet bleibt, bis alle gewünschten Spin-Echosignale erfaßt sind.

7. Gerät nach Anspruch 1,

dadurch gekennzeichnet, daß mittels der 90°-HF-Impulse mehrere parallele Ebenen der zu untersuchenden Probe gleichzeitig angeregt werden und die überlagerten Signale erfaßt werden.

8. Gerät nach Anspruch 1,

dadurch gekennzeichnet, daß mittels der selektiven 90°-HF-Impulse mehrere parallele Ebenen des zu untersuchenden Körpers gleichzeitig angeregt werden und die überlagerten Signale ausgelesen werden, wobei durch eine geeignete Anregungssequenz in einer Abfolge mehrerer Meßzyklen gewährleistet ist, daß die gewonnenen Meßwerte rechnerisch wieder den einzelnen Ebenen zugeordnet werden können.

## Claims

1. Apparatus for representing the distribution of a nuclear magnetic resonance characteristic occurring in a cross-sectional plane of a component, such as the nuclear spin density for example, in the form of a line-by-line image point scanning raster comprising N image points in each scanning line,

(a) with coils (1-4) which generate a fundamentally homogeneous, static constant magnetic field in which the component is arranged; and

(b) with gradient coils (7, 8), a high-frequency coil (9) and a process computer (18) which drives the gradient coils (7, 8) and the high-frequency coil (9);

characterised in that the process computer is designed to carry out the following sequence of steps N-times:

(i) the constant magnetic field generated by the coils (1-4) has superimposed thereon a gradient field $G_z$ generated by the gradient coils (7, 8), the direction of which is identical to that of the constant magnetic field but exhibits magnitude changes in this direction or in a direction at right angles thereto, the high-frequency coil (9) being simultaneously acted upon by an HF-pulse, the duration of which amounts to N-times a predetermined basic time unit $\Delta t$, and whose frequency and form are selected such that only spins in a plane of the component at right angles to the field strength gradient of the first gradient field achieve resonance with the field of the HF-pulse;

(ii) following disconnection of the HF-pulse and of the first gradient field, the constant magnetic field has simultaneously superimposed thereon a second gradient field $G_x$ of the duration $(N/2) \cdot \Delta t$ and a third gradient field $G_y$ of variable duration, the field directions of which each correspond to that of the constant magnetic field, and the field strength gradients of which extend at right angles to one another and to the field strength gradient of the first gradient field;

(iii) at a predetermined time following the disconnection of the second and third gradient fields, the high frequency coil (9) is acred upon by a 180° HF-pulse, at the end of which the constant magnetic field again has simultaneously superimposed thereon the first gradient field for the duration $(N/2) \cdot \Delta t$ and the third gradient field for a variable time duration; and

(iv) following the disconnection of the gradient fields in accordance with step (iii) the constant magnetic field again has superimposed thereon the second gradient field for the duration $N \cdot \Delta t$ and in the presence of the second gradient field the values of the spin echo signal produced by the 180° HF-pulse are determined at N consecutive instants and subjected to Fourier transformation;

## 0 074 022

where in each case from one sequence to the next the duration of the third gradient field $G_y$ is changed in step (ii) and in step (iii) such that after N sequences the difference in the time integrals formed before and after the 180° HF-pulse over this gradient field has passed through the values from (-N/2)-times to (N/2-1)-times an increment $\Delta t \cdot G_y$.

2. Apparatus as claimed in Claim 1, <u>characterised in that</u> in the steps which follow the first step, finite rise and build up times of the gradient fields are compensated in that constant extensions are added to the duration of the connection of the gradient fields, where the contribution of the additional interval of the length $N^-_G \cdot \Delta t$ before the 180° HF-pulse is compensated by the contribution of the additional interval $N^-_G \cdot \Delta t$ after the 180° HF-pulse including the influence of the finite rise times, where the additional interval is selected by means of the predetermined numerical values $N^-_G$ and $N^+_G$ such that the gradient field is stationary.

3. Apparatus as claimed in Claim 1, <u>characterised in that</u> by means of a second 180° HF-pulse, which has the opposite sign to that corresponding to step (iii) and which has a timing set between the second gradient field in accordance with step (iv) and a subseqquently additionally connected second gradient field which corresponds to the gradient field in accordance with step (iv), the spin echo signals produced by the second 180° HF-pulse are determined in a fashion corresponding to step (iv).

4. Apparatus as claimed in Claim 3, <u>characterised in that</u> in the further steps, further 180° HF-pulses are each connected with alternating phase positions, whereupon the spin echo signals are determined in accordance with step (iv), and that prior to the reconstructed Fourier transformation the measured values of all the uneven echoes are added, as are the measured values of all the even echoes.

5. Apparatus as claimed in Claim 4, <u>characterised in that</u> prior to the addition, differences or quotients between earlier and later echoes are formed.

6. Apparatus as claimed in Claim 3 or Claim 4, <u>characterised in that</u> in the case of short 180° HF-pulses having sufficiently powerful spectral breadth, the second gradient field remains connected from step (iv) onwards until all the desired spin echo signals have been determined.

7. Apparatus as claimed in Claim 1, <u>characterised in that</u> by means of the 90° HF-pulses a plurality of parallel planes of the sample to be investigated are simultaneously excited and the superimposed signals determined.

8. Apparatus as claimed in Claim 1, <u>characterised in that</u> by means of selective 90° HF-pulses a plurality of parallel planes of the component to be investigated are simultaneously excited and the superimposed signals are read, where, by a suitable excitation sequence in a succession of a plurality of measuring cycles, it is ensured that the measured values obtained can be arithmetically re-assigned to the individual planes.

**Revendications**

1. Procédé pour représenter la distribution, qui existe dans un plan de coupe transversale d'un corps, d'une caractéristique de spins nucléaires, par exemple la densité de spins nucléaires, sous la forme d'un réseau de points d'image, disposés sous la forme de lignes et comportant respectivement N points d'image pour chaque ligne du réseau, et comportant:

a) des bobines (1-4), qui produisent un champ magnétique statique continu essentiellement homogène, dans lequel on place le corps,

b) des bobines de gradient (7, 8), une bobine à haute fréquence (9) et un calculateur de processus (18), à l'aide duquel les bobines de gradient (7, 8) et la bobine à haute fréquence (9) sont commandées;

caractérisé en ce que le calculateur de processus est conçu pour exécuter N fois la séquence suivante de pas:

(i) on superpose, au champ magnétique continu produit par les bobines (1-4), un champ irrotationnel $G_Z$ produit par les bobines de gradient (7, 8) et dont la direction coïncide avec celle du champ magnétique continu et dont l'intensité varie dans cette direction ou dans une direction perpendiculaire à la précédente, et on applique simultanément à la bobine à haute fréquence (9) une impulsion HF, dont la durée est égale à N fois une unité de temps de base prédéterminée $\Delta t$ et dont la fréquence et la forme sont choisies de telle sorte que seuls les spins situés dans un plan du corps, qui est perpendiculaire au gradient d'intensité du premier champ irrotationnel, entrent en résonance avec le champ de l'impulsion HF,

(ii) après interruption de l'impulsion HF et du premier gradient irrotationnel, on superpose au champ magnétique continu simultanément un second champ irrotationnel $G_x$ pendant la durée $(N/2) \cdot \Delta t$ ainsi qu'un troisième champ irrotationnel $G_y$ possédant une durée variable, les directions de ces champs correspondant respectivement à celle du champ magnétique continu et les gradients d'intensité de ces champs étant aussi bien perpendiculaires entre eux qu'au gradient d'intensité du premier champ irrotationnel,

(iii) à un instant prédéterminé après l'apparition des second et troisième champs irrotationnels, on charge la bobine à haute fréquence (9) avec une impulsion HF à 180°, à la fin de laquelle on superpose à nouveau simultanément, au champ magnétique continu, le premier champ irrotationnel possédant la durée (N/2) · Δt ainsi que le troisième champ irrotationnel pendant un intervalle de temps variable,

(iv) après le débranchement des champs irrotationnels conforment au pas (iii), on superpose à nouveau le second champ irrotationnel pendant la durée N · Δt au champ magnétique continu, on détecte les valeurs du signal d'écho de spins provoqué par l'impulsion HF à 180°, en présence du second champ irrotationnel, en N instants successifs et on soumet ces valeurs à une transformation de Fourier,

auquel cas on modifie respectivement d'une séquence à la suivante, la durée du troisième champ irrotationnel $G_y$ respectivement lors du pas (ii) ou du pas (iii), de manière que la différence de l'intégrale dans le temps formée avant et après une impulsion HF à 180°, dans ce champ irrotationnel, est passée, au bout de N séquences, par les valeurs allant de (-N/2) fois jusqu'à (N/2-1) fois un incrément Δt · $G_y$.

2. Appareil suivant la revendication 1, caractérisé par le fait qu'au cours des pas qui succèdent au premier pas, on compense des temps fini de montée et des temps finis d'installation transitoire des champs irrotationnels, en ajoutant à la durée d'application des champs irrotationnels, des retards constants, auquel cas la contribution d'intervalles supplémentaires de durée $N_G^-$ · Δt avant l'impulsion HF à 180° est compensée par la contribution d'un intervalle supplémentaire $N_G^+$ · Δt après l'impulsion HF à 180°, y compris l'influence des temps finis de montée, l'intervalle supplémentaire étant choisi, grâce aux valeurs chiffrées prédéterminées $N_G^-$ et $N_G^+$, suffisamment long pour que le champ irrotationnel soit stationnaire.

3. Appareil suivant la revendication 1, caractérisé par le fait qu'à l'aide d'une seconde impulsion HF à 180°, qui possède un signe opposé à l'impulsion HF à 180° mise en oeuvre lors du pas (iv) et qui est située, dans le temps, entre le second champ irrotationnel correspondant au pas (iv) et un second champ irrotationnel appliqué ultérieurement en supplément et correspondant au champ irrotationnel conforme au pas (iv), on détecte les signaux d'échos de spins qui sont provoqués par la seconde impulsion HF à 180°, de la manière que lors du pas (iv).

4. Appareil suivant la revendication 3, caractérisé par le fait qu'au cours de pas supplémentaires, on applique des impulsions HF à 180° supplémentaires possédant des positions de phase qui alternent respectivement et qu'on détecte ensuite les signaux d'échos de spins conformément au pas (iv) et qu'avant la mise en oeuvre des transformations de Fourier de reconstitution, on additionne les valeurs de mesure de tous les échos impairs et on additionne également les valeurs de mesure de tous les échos pairs.

5. Appareil selon la revendication 4, caractérisé par le fait qu'avant l'addition, on forme des différences ou des quotients entre des échos antérieurs et des échos ultérieurs.

6. Appareil suivant l'une des revendications 3 ou 4, caractérisé par le fait que dans le cas d'impulsions HF à 180° brèves et suffisamment intenses au sens de l'obtention d'une largeur spectrale suffisante, le champ irrotationnel reste branché à partir du pas (iv), jusqu'à ce que tous les signaux d'échos de spins désirés soient détectés.

7. Appareil suivant la revendication 1, caractérisé par le fait qu'à l'aide d'impulsions HF à 90°, on excite simultanément plusieurs plans parallèles de l'échantillon à examiner et on détecte les signaux superposés.

8. Appareil suivant la revendication 1, caractérisé par le fait qu'à l'aide des impulsions HF à 90° sélectives, on excite simultanément plusieurs plans parallèles du corps à examiner et on lit les signaux superposés, auquel cas une séquence appropriée d'excitation garantit, au cours d'une suite de plusieurs cycles de mesure, que les valeurs de mesure obtenues peuvent être à nouveau associées, par calcul, aux plans individuels.

FIG 1

1

0 074 022

FIG 2

FIG 3

FIG 4   für $k_y > 0$

FIG 5   für $k_y < 0$

FIG 6   $k_y > 0$

FIG 7   $k_y < 0$

3

FIG 8

FIG 9

FIG 10

FIG 11